# EUROPEAN PATENT SPECIFICATION

(11) **EP 3 232 467 B1**
(45) Date of publication and mention of the grant of the patent: **10.06.2020**
(21) Application number: 14907653.1
(22) Date of filing: 09.12.2014
(51) Int. Cl.: H01L 23/552, H01L 23/495

(54) **SEMICONDUCTOR PACKAGE**
HALBLEITERGEHÄUSE
BOÎTIER DE SEMI-CONDUCTEUR

(43) Date of publication of application: 18.10.2017
(73) Proprietor: Mitsubishi Electric Corporation, Chiyoda-ku Tokyo 100-8310 (JP)
(72) Inventor: MIZUTANI, Hiroyuki, Tokyo 100-8310 (JP); ISHIBASHI, Hidenori, Tokyo 100-8310 (JP); YOSHIOKA, Hideharu, Tokyo 100-8310 (JP); ISHIDA, Kiyoshi, Tokyo 100-8310 (JP)
(74) Representative: Pfenning, Meinig & Partner mbB
(86) International application number: PCT/JP2014/082544
(87) International publication number: WO 2016/092633

(56) References cited:
- DE-A1- 10 148 043
- JP-A- 2002 033 444
- JP-A- 2007 507 108
- US-A1- 2005 067 676
- US-A1- 2011 049 685
- US-B1- 8 053 872

## Description

### TECHNICAL FIELD

The present invention relates to a semiconductor package that has a function of shielding electromagnetic waves.

### BACKGROUND ART

Semiconductor packages having various structures are used, each of which contains an electronic component such as an integrated circuit (IC) chip. Among these semiconductor packages, the one having a lead frame is widely used (e.g., a Quad Flat No Lead (QFN) package). The lead frame is made of thin plate metal which is used for fixing the IC chip and also used as an internal wire of the semiconductor package.

In the semiconductor package, such as the QFN package, the IC chip is bonded to a die pad of the lead frame with silver paste, solder, or the like. A terminal of the lead frame and the IC chip are electrically connected via a gold wire or an aluminum wire. After that, the IC chip and the wire are sealed by epoxy resin or the like in order to protect against humidity, dust, and external stress. The semiconductor package is manufactured through the above-described process. Those semiconductor packages may bring an advantage of being inexpensive and being excellent at the radiation of heat which is occurring in the IC chip.

Meanwhile, as for an electronic device, it is required to suppress unnecessary electromagnetic interference between electronic components in order to prevent malfunction. In the above-described semiconductor package, part of signals input or output to/from the IC chip may be radiated from the terminal and the wires as electromagnetic waves. Although the IC chip is covered with epoxy resin or the like, it is not covered with a conductive member such as metal. Therefore, electromagnetic waves are radiated outside from the semiconductor package. When the radiated electromagnetic waves cause interference between a plurality of semiconductor packages, the malfunction of the electronic device may occur.

As a semiconductor package which is capable of shielding electromagnetic waves occurring in the package, there is a structure disclosed in Patent Literature 1, for example. This is a semiconductor package, in which an IC chip is covered by a ceramic or metal cap having surfaces covered with conductive material, and the cap is attached to a radiator plate via a fin and a screw being attached to the side of the cap. In the semiconductor package, the cap, the fin, the screw, and the radiator plate are formed of conductive members, such as metal, and are electrically connected. Therefore, electromagnetic waves can be shielded.

In addition, as disclosed in Patent Literature 2, there is a structure, in which an IC chip is mounted on a printed circuit board in place of the lead frame, and wire bonding and resin molding are performed, and, after that, the surface of the molded resin is coated with an electromagnetic wave shielding coating.

US8053872B1 discloses a method that integrates a shield on a flat, no-lead (FN) semiconductor package, which has multiple rows of contact pads along any side. The FN semiconductor package will have at least one inner row and one outer row of contact pads on at least one side. The inner and outer rows of contact pads and a die attach pad form the foundation for the FN semiconductor package. A die is mounted on the die attach pad and connected by wirebonds to certain contact pads of the inner rows of contact pads. An overmold body is formed over the die, die attach pad, wirebonds, and inner row of contact pads, and substantially encompasses each contact pad of the outer row of contact pads. A conformal coating is applied over the overmold body, including the exposed surfaces of the contact pads of the outer row of contact pads, providing a shield.

US2005067676A1 discloses a method for forming an electromagnetic interference (EMI) and/or electromagnetic radiation shield by forming a conductive layer (42, 64) over a mold encapsulant (35, 62). The conductive layer (42, 64) may be electrically coupled using a wire to the leadframe (10, 52) of the semiconductor package (2, 50). The electrical coupling can be performed by wire bonding two device portions (2, 4, 6, 8) of a leadframe (10) together and then cutting the wire bond (32) by forming a groove (40) in the overlying mold encapsulant (35) to form two wires (33). The conductive layer (42) is then electrically coupled to each of the two wires (33). In another embodiment, a looped wire bond (61) is formed on top of a semiconductor die (57). After mold encapsulation, portions of the mold encapsulant (62) are removed to expose portions of the looped wire bond (61). The conductive layer (64) is then formed over the mold encapsulant (62) and the exposed portion of the looped wire bond (61) so that the conductive layer (64) is electrically coupled to the looped wire bond (61).

US2011049685A1 discloses a quad flat no leads (QFN) semiconductor device or package including a leadframe wherein the leads of the leadframe are selectively formed so that portions one or more prescribed leads are exposed in a package body of the semiconductor package and electrically connected to an electromagnetic interference (EMI) shielding layer applied to the package body. In certain embodiments, one or more tie bars of the leadframe may also be formed so as to be exposed in the package body of the semiconductor package and electrically connected to the shielding layer applied to the package body. Thus, the shielding layer may be electrically connected to one or more leads alone or in combination with one or more tie bars of the leadframe.

Another semiconductor package including an electronic component, terminals, and a molded resin to seal the electronic component is disclosed in Prior art document DE 101 48 043 A1.

Patent Literature 1: JP 2003-31987 A
Patent Literature 2: JP 2009-290217 A

### SUMMARY OF INVENTION

The present invention is defined in claim 1.

### BRIEF DESCRIPTION OF DRAWINGS

FIG. 1 is a cross-sectional diagram illustrating a configuration of a semiconductor package according to an example, which does not fall within the scope of the claimed invention and is described for illustrative purposes.
FIG. 2 is a diagram illustrating a manufacturing process of the semiconductor package according to the example not falling within the scope of the claimed invention.
FIG. 3 is a diagram illustrating another manufacturing process of the semiconductor package according to the example not falling within the scope of the claimed invention.
FIG. 4 is a cross-sectional diagram illustrating a configuration of a semiconductor package according to an Embodiment of the present invention.
FIG. 5 is a cross-sectional diagram illustrating a configuration of a semiconductor package according to another example, which does not fall within the scope of the claimed invention and is described for illustrative purposes only.
FIG. 6 is a diagram illustrating a manufacturing process of the semiconductor package according to the example shown in FIG. 5, the description of the manufacturing process being useful for understanding the invention, even though the process itself does not fall within the scope of the claimed invention.

### DESCRIPTION OF AN EMBODIMENT

Examples not covered by the claim and one embodiment of the present invention will be described in detail below with reference to the drawings. It should be noted that the invention is defined by the appended claim. The examples described herein, in addition to the single embodiment, are meant for illustrative purposes and serves to facilitate the reader's understanding.

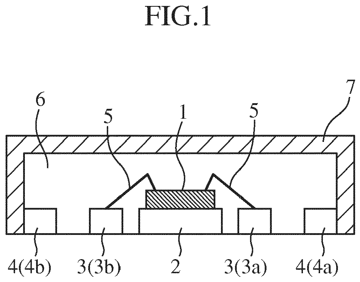

FIG. 1 is a cross-sectional diagram illustrating a configuration of a semiconductor package according to an example which is not according to the claimed invention.

The semiconductor package uses a lead frame being thin plate metal, and has a built-in IC chip (electronic component) 1. As illustrated in FIG. 1, the lead frame has a die pad 2, on which the IC chip 1 is fixed, and first terminals 3 being internal wires of the semiconductor package. The IC chip 1 is disposed on the top surface of the die pad 2. The die pad 2 is utilized for heat radiation as well as fixing of the IC chip 1.

The first terminals 3 are disposed to surround the die pad 2 on a package plane. The first terminals 3 are used for inputting and outputting signals or power. In FIG. 1, two first terminals 3a and 3b are depicted. The bottom surfaces of the first terminals 3 are exposed to the outside. The first terminals 3 are formed to be connectable to a signal terminal or a power supply terminal on a printed circuit board (not illustrated) on which the semiconductor package is to be mounted. The other surfaces of the first terminals 3 are covered with molded resin 6. Note that, in a case where many signal terminals or power supply terminals are needed, the first terminals 3 may be formed to be wound twice or more.

The lead frame also has a second terminal 4 disposed to surround the first terminals 3 on the package plane. The second terminals 4 may be discretely disposed in an island-shaped manner, or may be connected to be a series. In the example illustrated in FIG. 1, two terminals 4a and 4b are depicted, each of which is the second terminal 4. The bottom surface of the second terminal 4 is exposed to the outside. The second terminal 4 is formed to be connectable to a ground terminal on the above-described printed circuit board (or formed to be capable of grounding). In addition, outer sides of the second terminal 4 (the left side of the terminal 4a and the right side of the terminal 4b in a view of FIG. 1) are exposed to the outside, or in contact with a conductive coating (conductive member) 7. The other surfaces of the second terminal 4 are covered with the molded resin 6.

A terminal on the IC chip 1 and the first terminals 3 are electrically connected via a wire 5. The IC chip 1 and the wire 5 are sealed by the molded resin 6 to protect against humidity, dust, and external stress.

The molded resin 6 is covered by the conductive coating 7. In the example illustrated in FIG. 1, the conductive coating 7 covers the top surface and the sides of the molded resin 6, and the outer sides of the second terminal 4. The conductive coating 7 and the second terminal 4 are electrically connected.

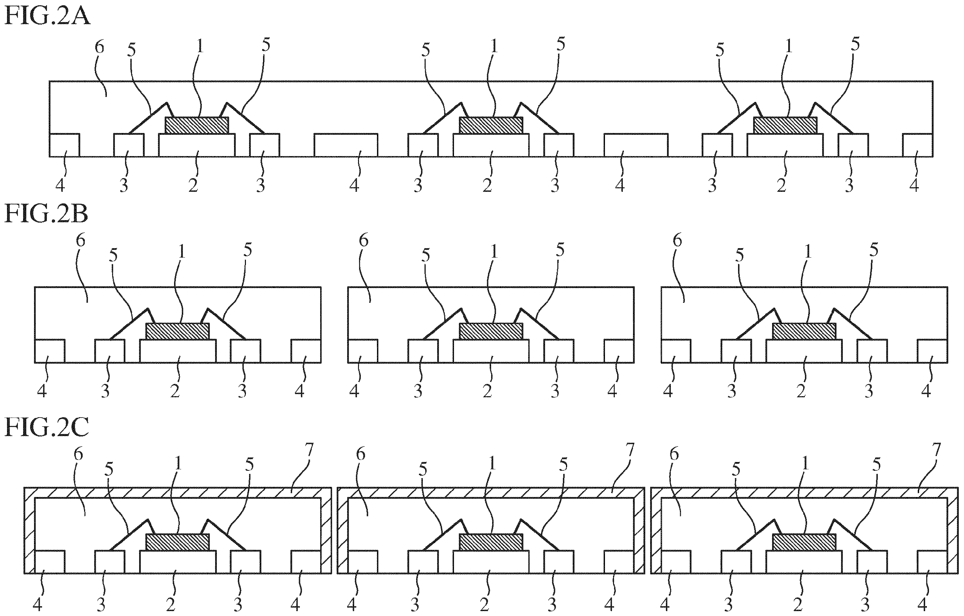

Next, a manufacturing process of the semiconductor package having the above-described configuration will be briefly described with reference to FIG. 2.

In the manufacturing process of the semiconductor package, a plurality of sets of die pads 2, first terminals 3 surrounding the die pads 2, and second terminals 4 surrounding the first terminals 3 are created at a predetermined interval by performing etching or the like on lead frame material. At this time, as illustrated in FIG. 2A, the second terminals 4 for every pair of adjacent semiconductor packages are integrally formed.

Next, the IC chip 1 is disposed on the top surface of the die pad 2, and is bonded to the die pad 2 with silver paste, solder, or the like. The first terminals 3 and a terminal on the IC chip 1 are connected via the wire 5. Subsequently, the IC chip 1 and the wire 5 are sealed by covering the surfaces of the lead frame material with the molded resin 6. A plurality of sets of chained packages as illustrated in FIG. 2A are thereby obtained.

After that, as illustrated in FIG. 2B, the semiconductor packages are separated into individual semiconductor packages by cutting the second terminals 4 for every pair of adjacent packages. Finally, as illustrated in FIG. 2C, each of the semiconductor packages is covered by the conductive coating 7.

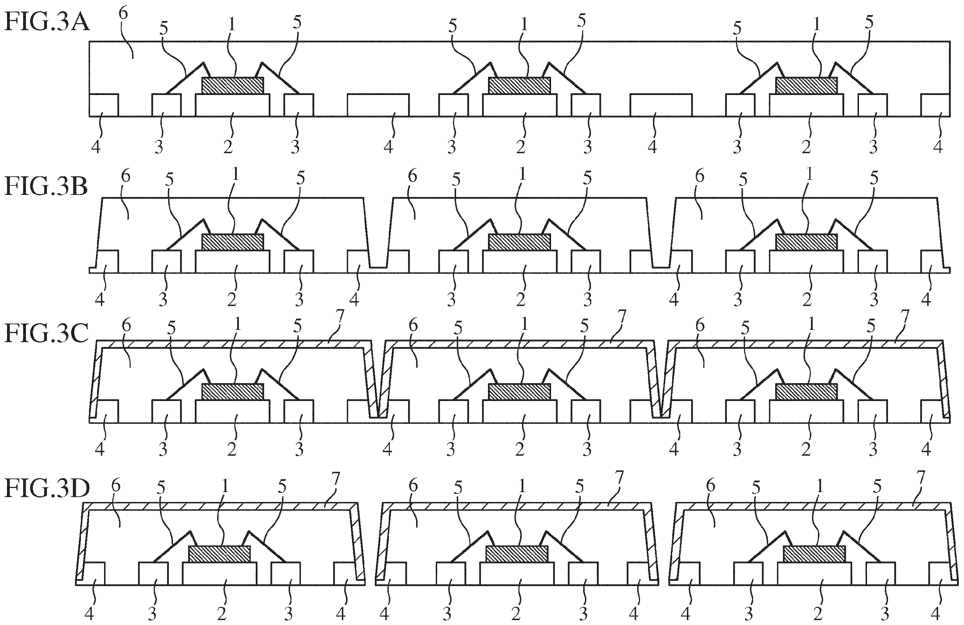

FIG. 2 illustrates a case where the sets of chained packages are separated into individual packages prior to covering each package by the conductive coating 7. Alternatively, as illustrated in FIG. 3, the packages may be separated into individual packages after being covered by the conductive coating 7.

More specifically, a plurality of sets of chained packages as illustrated in FIG. 3A are partway cut at the second terminals 4 for every pair of adjacent semiconductor packages as illustrated in FIG. 3B. Subsequently, as illustrated in FIG. 3C, each of the semiconductor packages are covered by the conductive coating 7. Finally, the packages are completely cut at the portions of the second terminals 4 for every pair of adjacent semiconductor packages to be separated into individual packages as illustrated in FIG. 3D.

Note that, various methods, such as plating, spraying, or application of the conductive member, or adhesion of the conductive coating, can be applied to form the conductive coating 7.

After that, the semiconductor package is reflowed to, for example, the printed circuit board, and the die pad 2 and the first and second terminals 3 and 4 are respectively connected to terminals formed on the printed circuit board. More specifically, the die pad 2 is connected to a terminal for heat radiation on the printed circuit board, the first terminals 3 are connected to a signal terminal or a power supply terminal on the printed circuit board, and the second terminal 4 is connected to a ground terminal on the printed circuit board.

Next, an operation of the semiconductor package having the above-described configuration will be described.

In the operation of the semiconductor package illustrated in FIG. 1, signals are input from one first terminal 3a, and are input to the IC chip 1 via the wire 5. The signals input to the IC chip 1 are output from the other one first terminal 3b via the wire 5 after having been subjected to a predetermined operation in the IC chip 1. Meanwhile, part of the signals input to the semiconductor package is radiated from the first terminals 3, the wire 5, and the like, as electromagnetic waves.

However, the semiconductor package illustrated in FIG. 1 is constructed such that the second terminal 4 and the conductive coating 7 are electrically connected, and the second terminal 4 is connected to a ground terminal on a printed circuit board (not illustrated). Therefore, the IC chip 1, the wire 5, and the first terminals 3 are shielded by the grounded second terminal 4 and conductive coating 7. As a result, electromagnetic waves radiated from the first terminals 3, the wire 5, and the like do not leak to the outside of the semiconductor package. In a similar manner, electromagnetic waves outside the semiconductor package are obstructed to enter the inside of the semiconductor package.

Heat occurring in the IC chip 1 is radiated via the die pad 2. Note that, in the semiconductor package of the present invention, the die pad 2 is excellent at heat radiation property because it is formed of lead frame material (metal).

Furthermore, in the present invention, a ceramic cap as in a conventional configuration is not used, but instead a lead frame is used. Therefore, the semiconductor package can be inexpensively formed. In addition, when the semiconductor package of the present invention is mounted on a printed circuit board or the like, a fin, a screw, and the like as in the conventional configuration are not needed. Thus, the semiconductor package can be downsized as compared to the conventional configuration.

As described above, according to the example, the lead frame includes the second terminal 4 that is disposed to surround the first terminals 3 and can be grounded, and the conductive coating 7 that covers the molded resin 6 and is electrically connected to the second terminal 4. Therefore, the semiconductor package is capable of downsizing the semiconductor package with inexpensive, and having better heat radiation property and shielding property for electromagnetic waves as compared with the conventional configuration.

### (Embodiment)

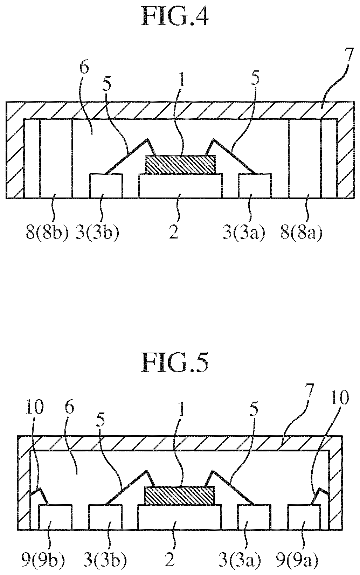

FIG. 4 is a cross-sectional diagram illustrating a configuration of a semiconductor package according to an Embodiment of the present invention. The semiconductor package according to the Embodiment illustrated in FIG. 4 is intended to replace, with a second terminal 8, the second terminal 4 of the semiconductor package according to the example illustrated in FIG. 1. Since the other configurations are similar to those in the example described before, the same signs are assigned, and the description thereof will be omitted.

The second terminal 8 is a terminal disposed to surround the first terminals 3. The second terminals 8 are discretely disposed in an island-shaped manner, or are connected to be a series. In the example illustrated in FIG. 4, two terminals 8a and 8b are depicted, each of which is the second terminal 8. The bottom surface of the second terminal 8 is exposed to the outside. The second terminal 8 is formed to be connectable to a ground terminal on the above-described printed circuit board (or formed to be capable of grounding). In addition, the top surface of the second terminal 8 is in contact with the conductive coating 7. The other surfaces of the second terminal 8 are covered with molded resin 6. In other words, unlike the second terminal 4 of the example described before, surfaces horizontal to the package plane (outer side) of the second terminal 8 are not in contact with the conductive coating 7.

The conductive coating 7 is formed to cover the top surface and the sides of the molded resin 6, and the top surface of the second terminal 8. The conductive coating 7 and the second terminal 8 are electrically connected.

Also in the configuration illustrated in FIG. 4, part of the signals input to the semiconductor package is radiated from the first terminals 3, the wire 5, and the like, as electromagnetic waves.

However, the semiconductor package illustrated in FIG. 4 is constructed such that the second terminal 8 and the conductive coating 7 are electrically connected, and the second terminal 8 is connected to a ground terminal on a printed circuit board (not illustrated). Therefore, the IC chip 1, the wire 5, and the first terminals 3 are shielded by the grounded second terminal 8 and the conductive coating 7. As a result, electromagnetic waves radiated from the first terminals 3, the wire 5, and the like do not leak to the outside of the semiconductor package. In a similar manner, electromagnetic waves outside the semiconductor package are obstructed to enter the inside of the semiconductor package.

As described above, according to the Embodiment, even if the second terminal 8 having the surfaces horizontal to the package plane, that are not in contact with the conductive coating 7, is used in place of the second terminal 4, effects similar to those in the example described before can be obtained.

In the structure in the example described before, the second terminal 4 is exposed to the sides of the semiconductor package in a state before the conductive coating 7 covers it. Thus, as illustrated in FIGS. 2 and 3, when the semiconductor packages are separated into individual packages, the second terminals 4 needs to be cut. When the second terminals 4 are cut, there brings about such a problem that burrs may arise on the cut surface, and a blade used for cutting may be early worn out.

In contrast, in the structure in the Embodiment, the second terminal 8 is not exposed to the sides of the semiconductor package in a state before the conductive coating 7 covers it. When the semiconductor packages are separated into individual packages, the molded resins 6 are cut. This may bring effects that the burrs do not arise on the cut surface, and the blade is prevented from being early worn out.

FIG. 5 is a cross-sectional diagram illustrating a configuration of a semiconductor package according to another example which is not according to the claimed invention. The semiconductor package according to the example illustrated in FIG. 5 is intended to replace, with a second terminal 9, the second terminal 4 of the semiconductor package according to the example illustrated in FIG. 1, and also intended to add a connection member 10. Since the other configurations are similar to the example illustrated in FIG. 1, the same signs are assigned, and the description thereof will be omitted.

The second terminal 9 is a terminal disposed to surround the first terminals 3. The second terminals 9 may be discretely disposed in an island-shaped manner, or may be connected to be a series. In the example illustrated in FIG. 5, two terminals 9a and 9b are depicted, each of which is the second terminal 9. The bottom surface of the second terminal 9 is exposed to the outside. The second terminal 9 is formed to be connectable to a ground terminal on the above-described printed circuit board (or formed to be capable of grounding). The other surfaces of the second terminal 9 are covered with molded resin 6. In other words, unlike the second terminal 4 of the example illustrated in FIG. 1, surfaces horizontal to the package plane (outer side) of the second terminal 9 are not in contact with the conductive coating 7.

In addition, the conductive coating 7 is formed to cover the top surface and the sides of the molded resin 6.

The connection member 10 electrically connects the second terminal 9 and the conductive coating 7. A wire, a ribbon (gold ribbon, aluminum ribbon, etc.) having a wider width than that of a wire being a thin line, or the like may be used as the connection member 10.

Also in the configuration illustrated in FIG. 5, part of the signals input to the semiconductor package is radiated from the first terminals 3, the wire 5, and the like, as electromagnetic waves.

However, the semiconductor package illustrated in FIG. 5 is constructed such that the second terminal 9 and the conductive coating 7 are electrically connected via the connection member 10, and the second terminal 9 is connected to a ground terminal on a printed circuit board (not illustrated). Therefore, the IC chip 1, the wire 5, and the first terminals 3 are shielded by the grounded second terminal 9 and the conductive coating 7. As a result, electromagnetic waves radiated from the first terminals 3, the wire 5, and the like do not leak to the outside of the semiconductor package. In a similar manner, electromagnetic waves outside the semiconductor package are obstructed to enter the inside of the semiconductor package.

As described above, according to this example, even if the second terminal 9 having the surfaces horizontal to the package plane, that are not in contact with the conductive coating 7, is used in place of the second terminal 4, and the connection member 10 for electrically connecting the second terminal 9 and the conductive coating 7 is provided, effects similar to those in the example illustrated in FIG. 1 can be obtained.

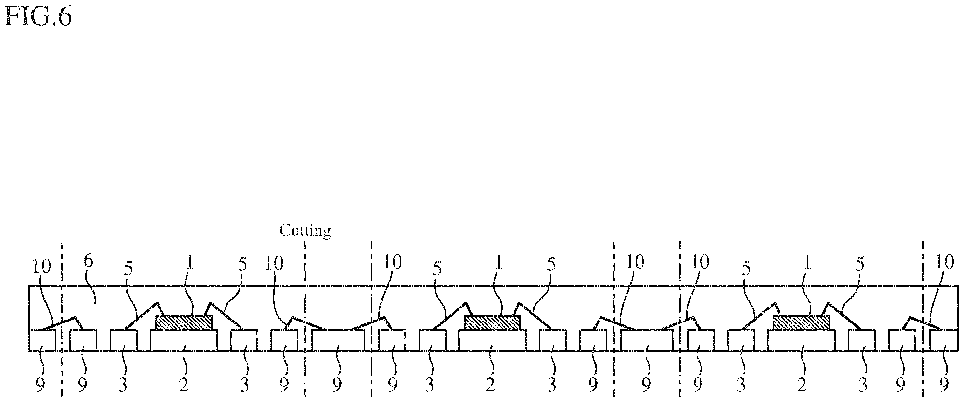

In addition, in the structure in this example, the second terminal 9 is not exposed to the sides of the semiconductor package in a state before the conductive coating 7 covers it. Thus, when the semiconductor packages are separated into individual packages as illustrated in FIG. 6, the molded resins 6 and the connection members 10 are cut. This may bring effects that burrs do not arise on the cut surface, and the blade is prevented from being early worn out.

In the present invention, an arbitrary constituent element in the embodiment can be modified, or an arbitrary constituent element in the embodiment can be omitted, within the scope of the invention, i.e. as long as the modification is still covered by the claim.

The semiconductor package according to the present invention is suitable for a semiconductor package which is required to be downsized with inexpensive, and to have better heat radiation property and shielding property for electromagnetic waves as compared with the conventional configuration.

- 1: IC chip (electronic component)
- 2: die pad
- 3: first terminals
- 4, 8, 9: second terminals
- 5: wire
- 6: molded resin
- 7: conductive coating (conductive member)
- 10: connection member

## Claims

1. A semiconductor package comprising:
an electronic component (1);
a lead frame that includes a die pad (2), on which the electronic component (1) is fixed, and first terminals (3; 3a, 3b) being internal wires;
wires (5) to connect the electronic component (1) and the first termi-nals (3; 3a, 3b);
molded resin (6) to seal the electronic component (1) and the wires (5);
a plurality of second terminals (8; 8a, 8b) disposed to surround the first terminals (3; 3a, 3b) on a package plane and formed to be capable of being grounded, said plurality of second terminals (8; 8a, 8b) being discretely disposed in an island-shaped manner or being connected to be a series, the second terminals (8; 8a, 8b) being included in the lead frame; and
a conductive coating (7) that covers a top surface and sides of the molded resin (6) and is electrically connected to the second terminals (8; 8a, 8b),
wherein a bottom surface of each of the second terminals (8; 8a, 8b) is exposed to the outside of the semiconductor package,
a top surface of each of the second terminals (8; 8a, 8b) is in contact with the conductive coating (7),
while all other surfaces of the second terminals (8; 8a, 8b) except their top surfaces and their bottom surfaces are covered with the molded resin (6) so that said all other surfaces of the second terminals (8; 8a, 8b) are not in contact with the conductive coating (7).

## Patentansprüche

1. Halbleitergehäuse, umfassend:
ein elektronisches Bauteil (1);
einen Leiterrahmen, der ein Die-Pad (2) aufweist, auf dem das elektronische Bauteil (1) befestigt ist, und erste Anschlüsse (3, 3a, 3b), welche innenliegende Leitungen sind;
Drähte (5) zum Verbinden des elektronischen Bauteils (1) und der ersten Anschlüsse (3; 3a; 3b);
geformtes Harz (6) zum Versiegeln des elektronischen Bauteils (1) und der Drähte (5);
eine Mehrzahl von zweiten Anschlüssen (8; 8a; 8b), so angeordnet, dass sie die ersten Anschlüsse (3; 3a; 3b) auf einer Gehäuseebene umgeben, und ausgebildet, geerdet werden zu können, wobei die Mehrzahl von zweiten Anschlüssen (8; 8a; 8b) einzeln inselförmig angeordnet sind oder verbunden sind, um eine Reihe zu bilden, wobei die zweiten Anschlüsse (8; 8a; 8b) im Leiterrahmen enthalten sind; und
eine leitfähige Beschichtung (7), die eine obere Oberfläche und Seiten des geformten Harzes (6) bedeckt und mit den zweiten Anschlüssen (8; 8a; 8b) elektrisch verbunden ist,
wobei eine untere Oberfläche von jedem der zweiten Anschlüsse (8; 8a, 8b) der Außenseite des Halbleitergehäuses ausgesetzt ist,
**dadurch gekennzeichnet, dass**
eine obere Oberfläche von jedem der zweiten Anschlüsse (8; 8a; 8b) in Kontakt mit der leitfähigen Beschichtung (7) steht,
während alle anderen Oberflächen der zweiten Anschlüsse (8; 8a; 8b) außer deren obere Oberflächen und deren untere Oberflächen so mit dem geformten Harz (6) bedeckt sind, dass die genannten anderen Oberflächen der zweiten Anschlüsse (8; 8a; 8b) nicht mit der leitfähigen Beschichtung (7) in Kontakt stehen.

## Revendications

1. Boîtier de semi-conducteur comprenant :
un composant électronique (1) ;
une grille de connexion qui comprend une plage de connexion de puce (2), sur laquelle est fixé le composant électronique (1), et des premières bornes (3 ; 3a, 3b) qui sont des fils internes ;
des fils (5) destinés à connecter le composant électronique (1) et les premières bornes (3 ; 3a, 3b) ;
une résine moulée (6) destinée à sceller le composant électronique (1) et les fils (5) ;
une pluralité de secondes bornes (8 ; 8a, 8b) disposées afin d'entourer les premières bornes (3 ; 3a, 3b) sur un plan de boîtier, et formées afin de pouvoir être mises à la masse, ladite pluralité de secondes bornes (8 ; 8a ; 8b) étant disposées de manière discrète d'une façon en forme d'îlots, ou étant connectées en série, les secondes bornes (8 ; 8a, 8b) étant incluses dans la grille de connexion ; et
un revêtement conducteur (7) qui recouvre la surface supérieure et les côtés de la résine moulée (6), et qui est connecté électriquement aux secondes bornes (8 ; 8a, 8b),
où une surface inférieure de chacune des secondes bornes (8 ; 8a, 8b) est exposée à l'extérieur du boîtier de semi-conducteur,
**caractérisé en ce que**
une surface supérieure de chacune des secondes bornes (8 ; 8a, 8b) est en contact avec le revêtement conducteur (7),
tandis que toutes les autres surfaces des secondes bornes (8 ; 8a, 8b), à l'exception de leurs surfaces supérieures et de leurs surfaces inférieures, sont recouvertes de la résine moulée (6), de telle sorte que toutes les autres surfaces des secondes bornes (8 ; 8a, 8b) ne soient pas en contact avec le revêtement conducteur (7).
